# EUROPEAN PATENT APPLICATION

(11) **EP 4 711 782 A1**
(43) Date of publication of application: **18.03.2026**
(21) Application number: 24849406.4
(22) Date of filing: 08.07.2024
(51) Int. Cl.: G01R 31/36, G01R 31/382, G01R 31/396, G01R 31/392, G01R 19/12, G01R 19/165, G01R 19/30

(54) **BATTERY MANAGEMENT APPARATUS AND OPERATION METHOD THEREFOR**

(30) Priority: 03.08.2023 KR 20230101824
(71) Applicant: LG Energy Solution, Ltd., Seoul 07335 (KR)
(72) Inventor: KIM, Min Jun, Daejeon 34122 (KR); CHUNG, Mi Kyung, Daejeon 34122 (KR); KOH, Dong Wook, Daejeon 34122 (KR); CHUN, Joo Young, Daejeon 34122 (KR)
(74) Representative: Plasseraud IP
(86) International application number: PCT/KR2024/009664
(87) International publication number: WO 2025/028836

(57) **Abstract**

A battery management apparatus according to an embodiment disclosed herein includes a sensor configured to obtain a voltage of a battery unit and a controller configured to generate a differential profile for a first differential value that is variance of the voltage with respect to a variance of a state of charge (SOC) of the battery unit, based on the SOC and the voltage of the battery unit, detect an SOC corresponding to each of second differential values included in a threshold range among second differential values obtained by differentiating the differential profile, detect, from the differential profile, peak values of the differential profile among first differential values corresponding to the detected SOC, and determine a state of the battery unit based on the peak values of the differential profile.

## Description

### [Technical Field]

### CROSS-REFERENCE TO RELATED APPLICATION

This application claims priority to and the benefit of Korean Patent Application No. 10-2023-0101824 filed in the Korean Intellectual Property Office on August 3, 2023, the entire content of which is incorporated herein by reference.

### TECHNICAL FIELD

Embodiments disclosed herein relate to a battery management apparatus and an operating method thereof.

### [Background Art]

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Recently, the lithium ion battery is attracting attention as a next-generation energy storage medium as a usage range thereof is expanded to a power source of electric vehicles.

The battery cell/module of the electric vehicle undergoes internal deformation and denaturation through various charges/discharges in production and use phases, such that physical and chemical characteristics thereof change. A technique for managing a state of the battery cell/module due to degradation and deterioration of the battery cell/module is required.

For various purposes such as state management of a battery, etc., a charging/discharging test may be conducted on the battery. A profile of an open circuit voltage (OCV) for a state of charge (SOC) of the battery may be estimated based on current and voltage obtained through the charging/discharging test. However, an actually measured OCV profile includes noise and an error, such that data for managing the state of the battery may not be clearly analyzed. Therefore, a method for accurately analyzing an OCV profile including noise and an error is required.

### [Disclosure]

### [Technical Problem]

Embodiments disclosed herein aim to provide a battery management apparatus and an operating method thereof in which a state of a battery unit may be managed based on an SOC and a voltage profile of a battery unit included in a battery pack.

Embodiments disclosed herein aim to provide a battery management apparatus and an operating method thereof in which a data processing algorithm is included to reduce an influence of noise included in an SOC and a voltage profile of a battery unit.

Technical problems of the embodiments disclosed herein are not limited to the above-described technical problems, and other unmentioned technical problems would be clearly understood by one of ordinary skill in the art from the following description.

### [Technical Solution]

A battery pack according to an embodiment disclosed herein includes a sensor configured to obtain a voltage of a battery unit and a controller configured to generate a differential profile for a first differential value that is variance of the voltage with respect to a variance of a state of charge (SOC) of the battery unit, based on the SOC and the voltage of the battery unit, detect an SOC corresponding to each of second differential values included in a threshold range among second differential values obtained by differentiating the differential profile, detect, from the differential profile, peak values of the differential profile among first differential values corresponding to the detected SOC, and determine a state of the battery unit based on the peak values of the differential profile.

According to an embodiment, the voltage may include an open circuit voltage (OCV).

According to an embodiment, the controller may be further configured to compare an absolute value of the second differential values with a predetermined threshold value to detect an SOC corresponding to each of the second differential values included in the threshold range.

According to an embodiment, the controller may be further configured to determine the state of the battery unit based on a first peak value and a second peak value that are peak values included in a region of interest among the detected peak values of the differential profile.

According to an embodiment, the controller may be further configured to manage the state of the battery unit based on a deviation between SOCs respectively corresponding to the first peak value and the second peak value.

According to an embodiment, the controller may be further configured to determine that the battery unit is deteriorated more as the deviation between the SOCs respectively corresponding to the first peak value and the second peak value is smaller.

A battery management method according to an embodiment disclosed herein includes generating a differential profile for a first differential value that is variance of a voltage with respect to a variance of a state of charge (SOC) of the battery unit, based on the SOC and the voltage of the battery unit, detecting an SOC corresponding to each of second differential values included in a threshold range among second differential values obtained by differentiating the differential profile, detecting, from the differential profile, peak values of the differential profile among first differential values corresponding to the detected SOC, and determining a state of the battery unit based on the peak values of the differential profile.

According to an embodiment, the voltage may include an OCV.

According to an embodiment, the detecting of the SOC corresponding to each of the second differential values included in the threshold range may include comparing an absolute value of the second differential values with a predetermined threshold value to detect an SOC corresponding to each of the second differential values included in the threshold range.

According to an embodiment, the determining of the state of the battery unit may include determining the state of the battery unit based on a first peak value and a second peak value that are peak values included in a region of interest among the peak values of the differential profile.

According to an embodiment, the determining of the state of the battery unit may include managing the state of the battery unit based on a deviation between SOCs respectively corresponding to the first peak value and the second peak value.

According to an embodiment, the determining of the state of the battery unit may include determining that the battery unit is deteriorated more as the deviation between the SOCs respectively corresponding to the first peak value and the second peak value is smaller.

### [Advantageous Effects]

The battery management apparatus and the operating method thereof according to an embodiment disclosed herein may manage a state of a battery unit based on an SOC and a voltage profile of the battery unit included in a battery pack.

The battery management apparatus and the operating method thereof according to an embodiment disclosed herein may include a data processing algorithm for reducing an influence of noise included in the SOC and the voltage profile of the battery unit.

Moreover, various effects recognized directly or indirectly from the disclosure may be provided.

### [Description of Drawings]

FIG. 1 illustrates a battery pack according to an embodiment disclosed herein.
FIG. 2 is a block diagram of a battery management apparatus according to an embodiment disclosed herein.
FIG. 3A is a diagram showing a profile according to an embodiment disclosed herein.
FIG. 3B is a diagram showing a primary differential profile according to an embodiment disclosed herein.
FIG. 3C is a diagram showing a secondary differential profile according to an embodiment disclosed herein.
FIG. 3D is a diagram showing a secondary differential profile according to another embodiment disclosed herein.
FIG. 3E is a diagram showing a primary differential profile according to another embodiment disclosed herein.
FIG. 3F is a diagram showing a primary differential profile according to yet another embodiment disclosed herein.
FIG. 4 is a flowchart of operations of a battery management apparatus, according to an embodiment disclosed herein.
FIG. 5 is a flowchart of operations of a battery management apparatus, according to another embodiment disclosed herein.
FIG. 6 is a block diagram showing a hardware configuration of a computing system for performing an operating method of a battery management apparatus, according to an embodiment disclosed herein.

### [Mode for Invention]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

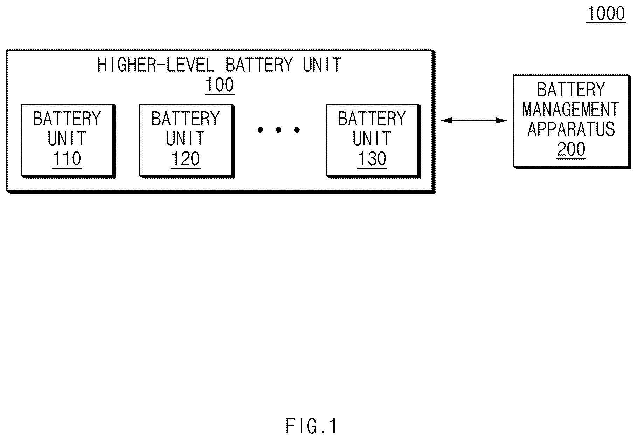

FIG. 1 illustrates a battery pack according to an embodiment disclosed herein.

Referring to FIG. 1, a battery pack 1000 may include a higher-level battery unit 100 and a battery management apparatus 200. The higher-level battery unit 100 may include a plurality of battery units 110, 120, ..., 130. According to an embodiment, the higher-level battery unit 100 may be a battery module included in a battery pack mounted inside an electric vehicle to supply power to the electric vehicle. When the higher-level battery unit 100 is a battery module, the plurality of battery units 110, 120, and 130 may be a plurality of battery cells. Although the higher-level battery unit 100 is illustrated as 1 in FIG. 1, the disclosure is not limited thereto, and the battery pack 1000 may include n higher-level battery units (n is a natural number equal to or greater than 2). In addition, some components may be excluded from the battery pack 1000 or other general-purpose components may be further included in the battery pack 1000.

The higher-level battery unit 100 may supply power to a target device (not shown). To this end, the higher-level battery unit 100 may be electrically connected to the target device. Herein, the target device may include an electrical, electronic, or mechanical device that operates by receiving power from the battery pack 1000 including the higher-level battery unit 100. For example, the target device may be, but not limited to, an electric vehicle (EV) or an energy storage system (ESS).

The higher-level battery unit 100 may include a plurality of battery units 110, 120, ..., 130. According to an embodiment, the plurality of battery units 110, 120, ..., 130 may be a basic unit of a battery cell available through charging/discharging of electric energy. For example, the battery cell may be a lithium ion (Li-ion) battery, an Li-ion polymer battery, a nickel-cadmium (Ni-Cd) battery, a nickel hydrogen (Ni-MH) battery, etc., and is not limited thereto. Although the plurality of battery units 110, 120, ..., 130 are illustrated in FIG. 1, the present disclosure is not limited thereto, and the higher-level battery unit 100 may include n battery units (n is a natural number equal to or greater than 2). Some components may be excluded from the higher-level battery unit 100 and/or the plurality of battery units 110, 120, ..., 130, or other general-purpose components may be further included in the higher-level battery unit 100 and/or the plurality of battery units 110, 120, ..., 130.

The battery management apparatus (a battery management system (BMS)) 200 may manage and/or control a state and/or an operation of the higher-level battery unit 100 and/or the plurality of battery units 110, 120, ..., 130. According to an embodiment, the battery management apparatus 200 may determine a state of the higher-level battery unit 100 and/or the plurality of battery units 110, 120, ..., 130, and manage the state of the higher-level battery unit 100 and/or the plurality of battery units 110, 120, ..., 130 based on the determination. According to an embodiment, the battery management apparatus 200 may control an operation of the higher-level battery unit 100 and/or the plurality of battery units 110, 120, ..., 130, and manage the operation of the higher-level battery unit 100 and/or the plurality of battery units 110, 120, ..., 130 based on the control.

In addition, the battery management apparatus 200 may monitor a voltage, a current, and/or a temperature, etc., of the higher-level battery unit 100 and/or each of the plurality of battery units 110, 120, and 130. A sensor or various measurement modules for monitoring performed by the battery management apparatus 200, which are not shown, may be additionally installed in any position of the higher-level battery unit 100, a charging/discharging path, the plurality of battery units 110, 120, ..., 130 included in the higher-level battery unit 100, etc.

The battery management apparatus 200 may calculate a parameter indicating a state of the higher-level battery unit 100 and/or each of the plurality of battery units 110, 120, ..., 130, e.g., a state of charge (SOC), a state of health (SOH) etc., based on a measurement value such as monitored voltage, current, temperature, etc. According to an embodiment, the battery management apparatus 200 may diagnose or determine the state of the higher-level battery unit 100 and/or the plurality of battery units 110, 120, ..., 130, based on a measured value and/or a calculated value obtained from the higher-level battery unit 100 and/or the plurality of battery units 110, 120, ..., 130.

The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

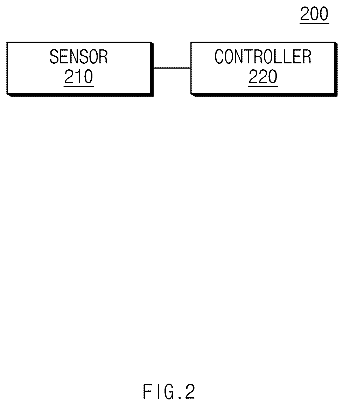

FIG. 2 is a block diagram of a battery management apparatus according to an embodiment disclosed herein.

Referring to FIG. 2, the battery management apparatus 200 may include a sensor 210 and a controller 220. However, without being limited thereto, some components may be omitted from the battery management apparatus 200 or other general-purpose components may be further included in the battery management apparatus 200.

The sensor 210 may monitor information of the higher-level battery unit 100 and/or each of the plurality of battery units 110, 120, and 130. The sensor 210 may obtain voltage, current, and/or temperature of the higher-level battery unit 100 and/or each of the plurality of battery units 110, 120, and 130 during charging and/or discharging.

Hereinbelow, for convenience of a description, the description will be made assuming that the higher-level battery unit 100 may be a battery module and each of the plurality of battery units 110, 120, ..., 130 is a battery cell. For convenience of a description, among the plurality of battery modules 110, 120, ..., 130, the battery unit 110 will be described as an example, but the description may be substantially identically applied to the other battery units 120, ..., 140.

According to an embodiment, the sensor 210 may obtain a voltage on opposite ends of the battery unit 110 during charging and discharging of the battery unit 110. The sensor 210 may obtain current applied to the battery unit 110 and charging time during charging and discharging of the battery unit 110.

According to an embodiment, the sensor 210 may obtain an open circuit voltage (OCV) of the battery unit 110. The OCV may mean a voltage excluding an influence of a battery current from a value obtained by subtracting a voltage drop caused by an internal resistance of the battery unit 110 from an output voltage, i.e., a no-load voltage (OCV).

The controller 220 may manage and/or control an operation of the battery unit 110. The controller 220 may manage an operation of the battery unit 110 based on information obtained by the sensor 210.

According to an embodiment, the controller 220 may process an algebraic and/or statistical operation based on the information obtained through the sensor 210. For example, the controller 220 may calculate a capacity and/or SOC of the battery unit 110 based on the current and the charging time of the battery unit 110, obtained from the sensor 210. The controller 220 may generate a function and/or profile (hereinafter, an OCV profile) related to the OCV of the battery unit 110 corresponding to the SOC of the battery unit 110, based on the voltage of the battery unit 110, obtained through the sensor 210.

According to an embodiment, the controller 220 may process an algebraic and/or statistical operation for the generated OCV profile. For example, the controller 220 may process various operations, such as differentiating or integrating the OCV profile, clustering values of the OCV profile, calculating a deviation, etc. An operation processible by the controller 220 is not limited thereto, and the controller 220 may process data by using various data processing methods and/or algorithms.

The controller 220 may determine or manage the state of the battery unit 110 based on the processed information.

According to an embodiment, as the battery unit 110 is used, the internal resistance of the battery unit 110 may increase, such that an output may be reduced and a charging capacity may be reduced. During charging and discharging of the battery unit 110, an electrochemical change may occur in the battery unit 110.

For example, when the battery unit 110 is an Li ion battery cell, an active material in an electrode of the battery cell may be reduced as the battery cell is used. The active material may be a material reacting with Li ions. For example, the active material may include a material such as, LFP, NCM, LMO, a combination thereof, etc. As the active material of the battery unit 110 is reduced, the OCV may change during charging and discharging of the battery unit 110. Thus, as the battery unit 110 is used, characteristics of the OCV profile of the battery unit 110 may change due to such a change in the active material.

Thus, the controller 220 may compare a changed OCV profile of charging and discharging of the battery unit 110 with an OCV profile at an initial stage of production of the battery unit 110 to determine the current state of the battery unit 110. According to an embodiment, the controller 220 may determine a deterioration state of the battery unit 110 by analyzing OCV data regarding an SOC of the battery unit 110. The controller 220 may determine the deterioration state of the battery unit 110 in a non-destructive method that does not physical destruct the battery unit 110, through OCV profile analysis for the SOC.

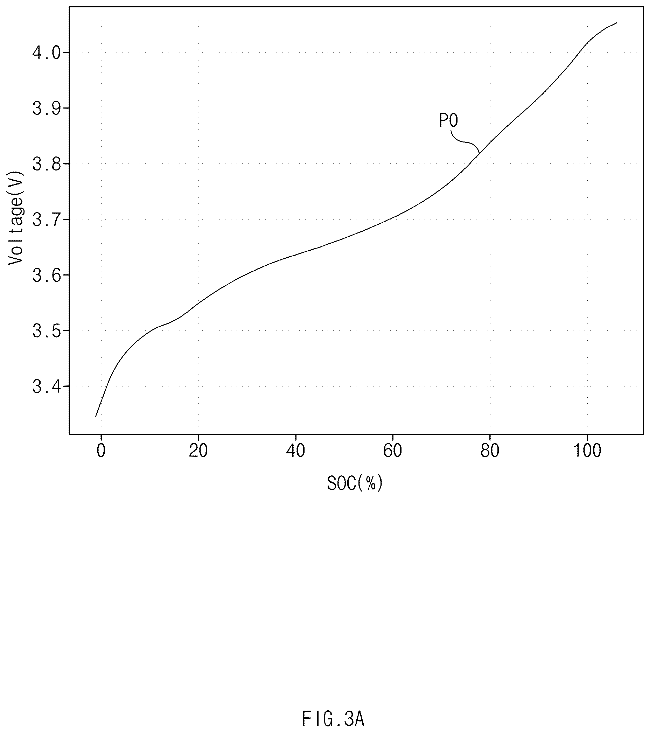

Hereinbelow, with reference to FIGS. 3A to 3E, a description will be made of an embodiment in which the controller 220 analyzes an OCV profile and determines the state of the battery unit 110.

According to an embodiment, FIGS. 3A to 3E may be views in an operating order of the controller 220. However, some operations may be excluded from FIGS. 3A to 3E or other general-purpose operations may be further included in FIGS. 3A to 3E.

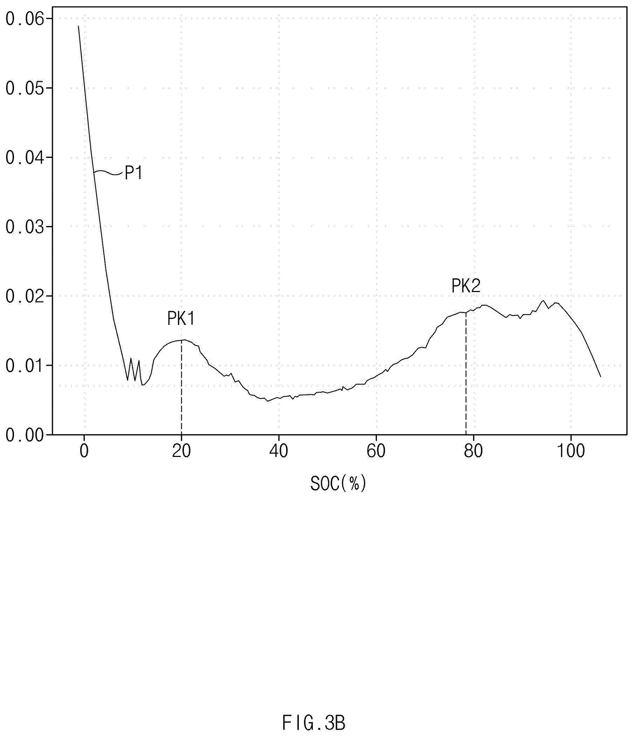

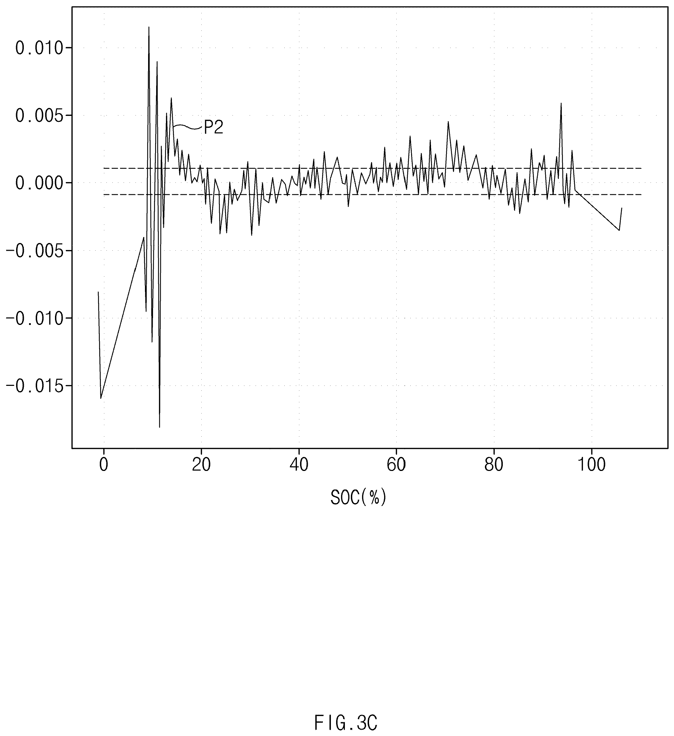

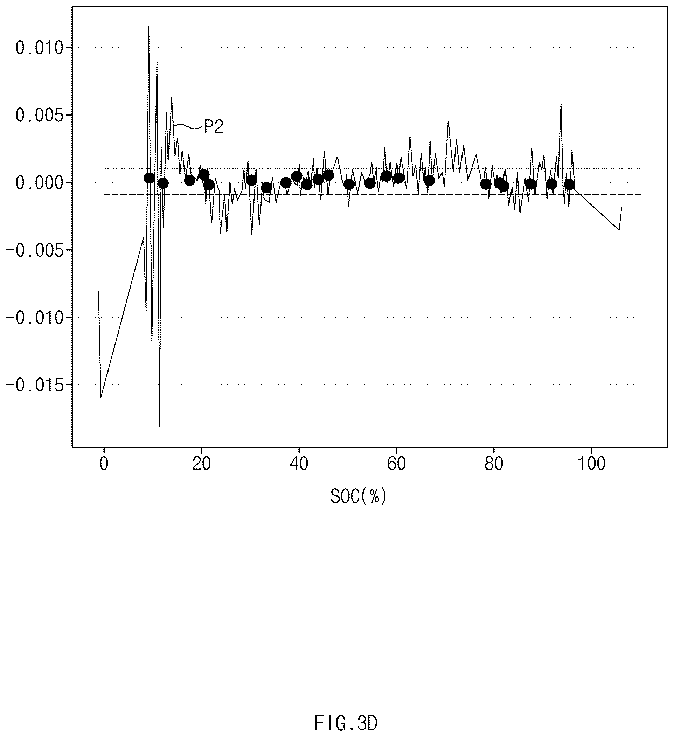

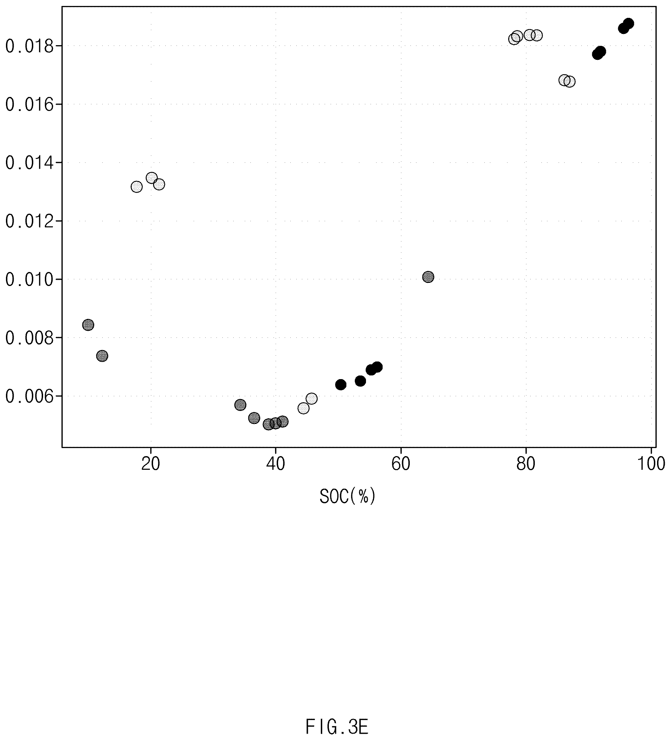

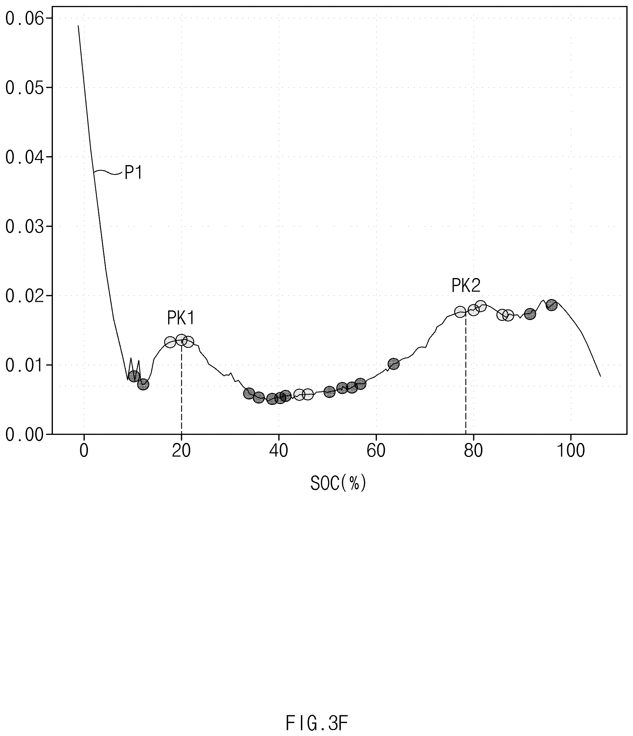

FIG. 3A is a diagram showing a profile according to an embodiment disclosed herein. FIG. 3B is a diagram showing a primary differential profile according to an embodiment disclosed herein. FIG. 3C is a diagram showing a secondary differential profile according to an embodiment disclosed herein. FIG. 3D is a diagram showing a secondary differential profile according to another embodiment disclosed herein. FIG. 3E is a diagram showing a primary differential profile according to another embodiment disclosed herein. FIG. 3F is a diagram showing a primary differential profile according to yet another embodiment disclosed herein.

Referring to FIG. 3A, the controller 220 may generate a profile P0 based on information of the battery unit 110, obtained by the sensor 210, during charging and discharging of the battery unit 110. According to an embodiment, the controller 220 may generate the profile P0 of a voltage V (in the unit of V) corresponding to a capacity Q (in the unit of Ah) of the battery unit 110. According to an embodiment, the controller 220 may generate the profile P0 based on the voltage of the battery unit 100 corresponding to the SOC of the battery unit 110, based on the SOC (in the unit of %) instead of the capacity Q. Herein, the SOC may be a value obtained by dividing the capacity Q of the battery unit 110 by a maximum capacity QMAX that is a constant value. Hereinbelow, for convenience of a description, an independent variable of the profile P0 is SOC (in the unit of %) and a dependent variable is a voltage (in the unit of V).

According to an embodiment, in the profile P0, the voltage of the battery unit 110 may be an OCV. According to an embodiment, the no-load voltage (OCV) of the battery unit 110 may be data that reflects the state of the battery unit 110 more. Thus, the controller 220 may accurately analyze the state of the battery unit 110 by analyzing the profile P0 generated based on the OCV.

According to an embodiment, the OCV profile P0 may be an X-Y graph in which the SOC is set as an independent variable X and the OCV is set as a dependent variable Y. That is, the OCV profile P0 may be defined as a graph showing an OCV and an SOC having an one-to-one relationship in the form of a function. According to an embodiment, the entire section of the SOC of the OCV profile P0 may be 0 % to 100 %.

The controller 220 may detect an inflection point of the OCV profile P0. The controller 220 may determine the state of the battery unit 110 based on the inflection point. According to an embodiment, the inflection point may be a point in which an instant variance of a secondary differential function is 0 and a sign of the instant variance of the secondary differential function changes. A point in which the sign of the instant variance of the secondary differential function changes may refer to a point at which concavity and/or convexity of the original function changes. For example, the inflection point may refer to a point at which the graph of the function changes from an upward-convex state to a downward-convex state or from a downward-convex state to an upward-convex state.

According to an embodiment, the controller 220 may set the OCV profile P0 indicating a correspondence between the SOC and the OCV as a function f(x) and differentiate the function f(x) twice to calculate a second-order function of the OCV profile P0, f"(x) (i.e., a secondary differential profile P2). Herein, it may be assumed that the function f(x) is continuous and differentiable twice. The controller 220 may determine, as the inflection point, a point at which f'(SOC)=0 in the second-order function f'(x) and a sign of f"(x) changes from positive to negative or from negative to positive based on f"(SOC).

In another aspect, the controller 220 may detect the inflection point of the OCV profile P0 through a local extreme point of a function f'(x) (i.e., the primary differential profile P1) obtained by differentiating the OCV profile P0 once. The local extreme point may be a point at which an instant variance of a primary differential function is 0. The local extreme point may include a local maximum point and a local minimum point. The local maximum point may be a point having the greatest function value in an arbitrary section, and the local minimum point may be a point having the least function value in the arbitrary section. The controller 220 may determine, as the local maximum point, a point at which f'(SOC)=0 and a sign of f"(x) changes from positive to negative in the first-order function f(x) (i.e., the primary differential profile P1), and as the local minimum point, a point at which f(SOC)=0 and the sign of f"(x) changes from negative to positive in the first-order function f'(x).

The inflection point of the OCV profile P0 may include information about various state changes of the battery unit 110. According to an embodiment, the inflection point of the OCV profile P0 corresponding to a specific section may include information about chemical reaction occurring during charging and discharging of the battery unit 110. Thus, the controller 220 may detect an inflection point located in a specific SOC section among inflection points of the OCV profile P0 and determine the state of the battery unit 110.

According to an embodiment, some of local maximum points (peak points) of the primary differential profile P1 may include information related to the deterioration state of the battery unit 110. Thus, the controller 220 may detect a peak point of the primary differential profile P1 of the OCV profile P0 to determine whether a chemical reaction related to the deterioration state of the battery unit 110 occurs in an SOC value of the battery unit 110. Meanwhile, a matter related to the peak point will be described with reference to FIGS. 3B to 3F.

According to an embodiment, the OCV profile P0 obtained during charging and discharging of the battery unit 110 may include noise. For example, the OCV profile P0 may include noise measured in a positive terminal or a negative terminal of the battery unit 110 and/or noise measured in various components connected to the battery unit 110. The OCV profile P0 may include noise according to a driving state of a vehicle including the battery unit 110. For example, the OCV profile P0 may include noise according to a driving state of the vehicle, such as sudden braking, sudden state, regenerative braking, etc. Thus, the controller 220 may not accurately determine the state of the battery unit 110 when analyzing the OCV profile P0 including noise.

Thus, the controller 220 may cluster perform clustering in the secondary differential profile P2 obtained by differentiating the OCV profile P0 twice and detect a peak value from the primary differential profile P1, obtained by differentiating the OCV profile P0 once based on the clustered data. In this way, the controller 220 may determine the state of the battery unit 110 without interference from noise during actual driving and/or charging and discharging. The controller 220 may also detect an inflection point of the OCV profile P0 (i.e., the peak point of the primary differential profile P1) without data smoothing of the OCV profile P0 including noise. The controller 220 may accurately determine the deterioration state of the battery unit 110, based on the detected inflection point of the OCV profile P0 (i.e., the peak point of the primary differential profile P1).

Referring to FIG. 3B, the controller 220 may generate a profile (i.e., the primary differential profile P1) obtained by differentiating the OCV profile P0 of the battery unit 110. The primary differential profile P1 may be a function regarding a variance of a voltage of the battery unit 110 with respect to a variance of an SOC of the battery unit 110.

According to an embodiment, the primary differential profile P1 may be an X-Y graph in which an SOC variance is set as a variable X and an OCV variance is set as a variable Y. According to an embodiment, the entire section of the SOC of the primary differential profile P1 may be 0 % to 100 %. According to an embodiment, a function value of the primary differential profile P1 may be a first differential value.

According to an embodiment, the primary differential profile P1 may include a plurality of local extreme points. The plurality of local extreme points may be points at which an instant variance of the primary differential profile P1 is 0.

The controller 220 may detect the inflection point of the OCV profile P0 through a peak point of a function f'(x) (i.e., the primary differential profile P1) obtained by differentiating the OCV profile P0 once. The controller 220 may determine, as a peak point, a peak at which an instant variance of the primary differential profile P1 is 0 and a differential voltage is greatest.

As described above, some of peak points of the primary differential profile P1 may include information related to the deterioration state of the battery unit 110. According to an embodiment, the controller 220 may determine and manage the state of the battery unit 110 based on peak points in the region of interest related to the deterioration state of the battery unit. According to an embodiment, the controller 220 may detect the first peak value PK1 and the second peak value PK2 located in a region of interest on the primary differential profile P1.

According to an embodiment, the region of interest may include a specific SOC section related to the deterioration state of the battery unit 110. For example, the region of interest may be a region in which a chemical reaction occurs in the battery unit 110 during charging and discharging. The chemical reaction occurring in the battery unit 110 may occur in a specific SOC section. This chemical reaction may occur due to a change in the active material present in the electrode of the battery unit 110, but the disclosure is not limited thereto.

According to an embodiment, the region of interest may be a part in which the SOC of the battery unit 110 is 10 % to 90 % of the entire section. According to an embodiment, the region of interest may be a part in which the SOC of the battery unit 110 is 15% to 80% of the entire section.

According to an embodiment, the controller 220 may determine the region of interest including a first SOC section and a second SOC section. The first SOC section may be a capacity section expected to include the first peak value PK1 and may be set to a specific section in which the capacity of the battery unit 110 is considered. Likewise, the second SOC section may be a capacity section expected to include the second peak value PK2 and may be set to a specific section in which the capacity of the battery unit 110 is considered. The first peak value PK1 and/or the second peak value PK2 may be related to a staging phenomenon where the lithium ion is desorbed during charging and discharging of the battery unit 110.

According to an embodiment of FIGS. 3A to 3F, the first SOC section may be set to an SOC section of 10 % to 30 % of the entire SOC section of the battery unit 110. The second SOC section may be set to an SOC section of 60% to 80 % of the entire SOC section of the battery unit 110. According to an embodiment, the controller 220 may detect a peak point around a part where the SOC of the battery unit 110 is 20 % and/or 75 % of the entire SOC section.

The controller 220 may detect the first peak value PK1 and the second peak value PK2 located in a region of interest on the primary differential profile P1. According to an embodiment, the controller 220 may detect the first peak value PK1 around a part where the SOC of the battery unit 110 is 20 % of the entire section and the second peak value PK2 around a part where the SOC is 80 %. According to an embodiment, the controller 220 may detect the first peak value PK1 around a part where the SOC of the battery unit 110 is 15 % of the entire section and the second peak value PK2 around a part where the SOC is 75 %.

The controller 220 may not accurately detect peak values in the region of interest due to noise included in the primary differential profile P1. Thus, a method for more accurately detecting the peak values in the region of interest will be described with reference to FIGS. 3C to 3F.

Referring to FIG. 3C, the controller 220 may generate the secondary differential profile P2 obtained by differentiating the primary differential profile P1. The secondary differential profile P2 may be a function regarding a variance of a first differential value with respect to a variance of an SOC of the battery unit 110. The controller 220 may detect the inflection point of the OCV profile P0 through the secondary primary differential profile P2.

According to an embodiment, the secondary differential profile P2 may be an X-Y graph in which an SOC variance is set as a variable X and a primary differential value variance with respect to an SOC variance is set as a variable Y. According to an embodiment, the entire section of the SOC of the secondary differential profile P2 may be 0 % to 100 %. According to an embodiment, a function value of the secondary differential profile P2 may be a second differential value.

The controller 220 may detect the inflection point of the OCV profile P0 by detecting a point at which the second differential value of the secondary differential profile P2 is within a threshold range. According to an embodiment, the threshold range may be a predetermined range including a point at which the second differential value is 0. According to an embodiment, the threshold range may include a range in which an absolute value of the second differential value is around 0.

According to an embodiment, the controller 220 may compare the absolute value of the second differential values with a predetermined threshold value to detect the inflection point of the OCV profile P0. For example, the predetermined threshold value may be a constant value greater than 0 by a small value.

The primary differential profile P1 may include noise during actual driving and/or charging and discharging like the OCV profile P0. Thus, a plurality of points not related to the chemical reaction occurring in the battery unit 110 may be detected as inflection points of the OCV profile P0. The controller 220 may detect points that may be inflection points in the OCV profile including noise by detecting the second differential values in the threshold range, i.e., the inflection points of the OCV profile.

Referring to FIG. 3D, the controller 220 may perform clustering in the secondary differential profile P2.

According to an embodiment, clustering may refer to an algorithm for classifying distributed data as a specific group. For example, the clustering algorithm may include well-known clustering algorithms such as k-means clustering, density-based clustering, Gaussian clustering, etc.

The controller 220 may cluster the secondary differential values in the threshold range detected in the secondary differential profile P2. According to an embodiment, the controller 220 may cluster the secondary differential values in the threshold range based on the SOC of the battery unit 110.

The secondary differential profile P2 may include noise during actual driving and/or charging and discharging like the OCV profile P0 and the primary differential profile P1. Thus, a plurality of points not related to the chemical reaction occurring in the battery unit 110 may be detected as inflection points of the OCV profile P0. The controller 220 may detect points that may be inflection points of the OCV profile P0 through the clustering algorithm, and reduce an influence of noise. The controller 220 may also detect an inflection point of the OCV profile P0 (i.e., the peak point of the primary differential profile P1) without smoothing OCV data of the battery unit 110.

According to an embodiment, the controller 220 may detect a representative value representing an SOC group for each clustered SOC group. For example, the representative value may be an SOC average of the clustered SOC group. The controller 220 may classify the SOC groups clustered based on the detected representative value.

Referring to FIG. 3E, the controller 220 may detect a function value of the primary differential profile P1 corresponding to the clustered SOC groups.

The controller 220 may detect first differential values, which corresponds to each of the clustered SOC groups, on the primary differential profile P1. According to an embodiment, the second differential values corresponding to each of the clustered SOC groups are close to 0, such that the controller 220 may not easily detect the peak value of the primary differential profile P1 merely by detecting the second differential values from the secondary differential profile P2. Thus, the controller 220 may detect the corresponding first differential values from the primary differential profile P1 based on the SOC groups clustered in the secondary differential profile P2. In this way, the controller 220 may accurately determine the state of the battery unit 110.

Referring to FIG. 3F, the controller 220 may detect peak values based on the detected first differential values. According to an embodiment, the controller 220 may detect peak values from among the detected first differential values.

According to an embodiment, the controller 220 may detect the first peak value PK1 and the second peak value PK2 included in a region of interest based on the detected peak values. A process of detecting the peak values included in the region of interest is the same as described with reference to FIG. 3B, and thus will not be described redundantly at this time.

The controller 220 may accurately detect a peak value from the primary differential profile P1 including noise, by detecting the peak value of the primary differential profile P1 through clustering. The controller 220 may accurately detect the first peak value PK1 and the second peak value PK2, located in a region of interest, through clustering. Thus, the controller 220 may detect the first peak value PK1 and the second peak value PK2, related to a chemical reaction occurring in the battery unit 110, without data smoothing.

According to an embodiment, the controller 220 may manage the state of the battery unit 110 based on the first peak value PK1 and the second peak value PK2. The controller 220 may determine the aging and/or deterioration degree of the battery unit 110 through a deviation between SOCs respectively corresponding to the first peak value PK1 and the second peak value PK2.

The controller 220 may determine that the battery unit 110 is deteriorated more as the SOC deviation between the SOC corresponding to the first peak value PK1 and the SOC corresponding to the second peak value PK2 is smaller. According to an embodiment, during repetition of charging and discharging of the battery unit 110, an active material capable of reacting with the Li ions may be reduced. For example, reduction of the active material capable of reaction may lead to reduction in an interval between inflection points in the OCV profile P0 of the battery unit 110. Thus, the controller 220 may determine the deterioration state of the battery unit 110 in a non-destructive method through the SOC deviation of the peak values on the primary differential profile P1 of the OCV profile P0.

The controller 220 described with reference to FIGS. 2 and 3A to 3F is not limited to the above-described configuration, and a general component required for operating the battery management apparatus 200 may be added to or omitted from the controller 220. According to an embodiment, the controller 220 may provide information about the battery unit 110 to the user terminal through a communication unit (not shown) and provide information about the battery unit 110 through a display provided in a vehicle, a charger, etc.

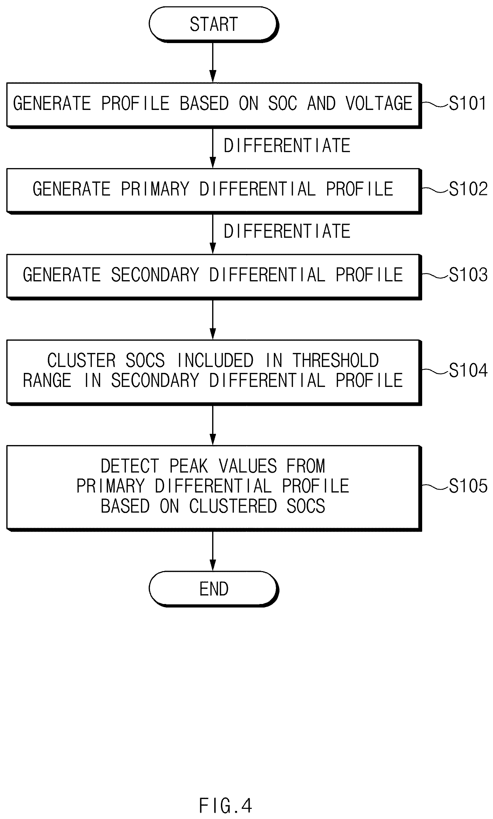

FIG. 4 is a flowchart of operations of a battery management apparatus, according to an embodiment disclosed herein.

Operations shown in FIG. 4 may be performed by the battery management apparatus 200 of FIG. 2.

In operation S101, the controller 220 may generate the profile P0 based on the SOC and the voltage of the battery unit 110. The generated profile P0 may be the OCV profile P0 for the SOC of the battery unit 110.

In operation S102, the controller 220 may generate the primary differential profile P1. According to an embodiment, the controller 220 may generate the primary differential profile P1 by differentiating the OCV profile P0. For example, the primary differential profile P1 may be a differential profile regarding a first differential value that is a variance of a voltage with respect to a variance of an SOC of the battery unit 110.

In operation S103, the controller 220 may generate the secondary differential profile P2. According to an embodiment, the controller 220 may generate the secondary differential profile P2 by differentiating the primary differential profile P1. For example, the secondary differential profile P2 may be a differential profile regarding a second differential value that is a variance of the first differential value with respect to the variance of the SOC of the battery unit 110.

In operation S104, the controller 220 may cluster SOC values included in a threshold range in the secondary differential profile P2. According to an embodiment, the controller 220 may detect an SOC corresponding to each of second differential values included in the threshold range among the second differential values. The controller 220 may cluster the second differential values based on the detected SOC. The controller 220 may detect a representative value of the clustered SOC groups.

In operation S105, the controller 220 may detect a peak value from the primary differential profile P1 based on the clustered SOC. According to an embodiment, the controller 220 may detect the peak values of the primary differential profile P1 among the first differential values corresponding to the detected SOC, from the primary differential profile P1. In another aspect, the controller 220 may detect the peak values of the primary differential profile P1 among the first differential values corresponding to the detected representative value, from the primary differential profile P1.

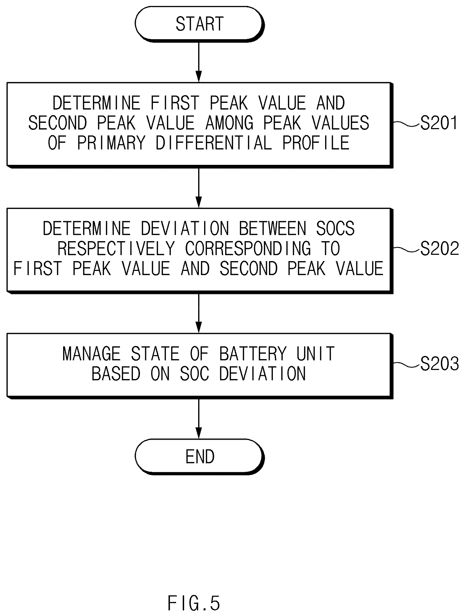

FIG. 5 is a flowchart of operations of a battery management apparatus, according to another embodiment disclosed herein.

Operations shown in FIG. 5 may be performed by the battery management apparatus 200 of FIG. 2.

In operation S201, the controller 220 may determine a first peak value PK1 and a second peak value PK2 among peak values of the primary differential profile P1. According to an embodiment, the controller 220 may determine, as the first peak value PK1 and the second peak value PK2, peak values included in a region of interest among the detected peak values of the primary differential profile P1.

In operation S202, the controller 220 may determine a deviation between SOCs corresponding to the first peak value PK1 and the second peak value PK2. According to an embodiment, the controller 220 may calculate a deviation based on a difference between the SOC corresponding to the first peak value PK1 and the SOC corresponding to the second peak value PK2.

In operation S203, the controller 220 may manage the state of the battery unit 110 based on the SOC deviation. According to an embodiment, the controller 220 may determine that the battery unit 110 is deteriorated more as the SOC deviation between the first peak value PK1 and the second peak value PK2 is smaller.

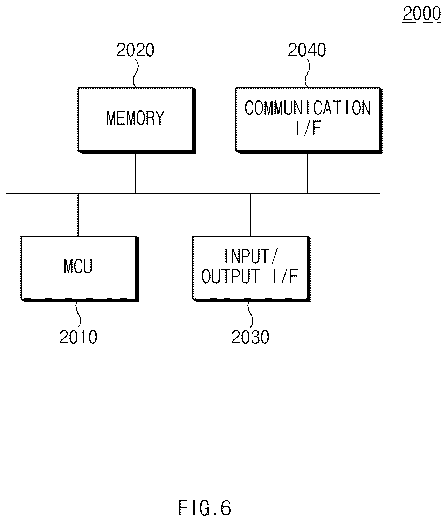

FIG. 6 is a block diagram showing a hardware configuration of a computing system for performing an operating method of the battery management apparatus 200, according to an embodiment disclosed herein.

Referring to FIG. 6, a computing system 2000 according to an embodiment disclosed herein may include an MCU 2010, a memory 2020, an input/output I/F 2030, and a communication I/F 2040.

The MCU 2010 may be a processor that executes various programs (e.g., a battery cell feature data collection program, a latent variable extraction program, a distribution generation program, a battery cell diagnosis program, etc.) stored in the memory 2020, processes various information including feature data, latent variables, etc., of the battery cell through these programs, and executes the above-described functions of the controller 220 included in the battery management apparatus 200 shown in FIGS. 1 to 5.

The memory 2020 may store various programs such as a battery cell feature data collection program, a latent variable extraction program, a distribution generation program, a battery cell diagnosis program, etc. Moreover, the memory 2020 may store various information such as feature data, a latent variable, etc., of the battery cell.

The memory 2020 may be provided in plural, depending on a need. The memory 2020 may be volatile memory or non-volatile memory. For the memory 2020 as the volatile memory, random access memory (RAM), dynamic RAM (DRAM), static RAM (SRAM), etc., may be used. For the memory 2020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2020 are merely examples and are not limited thereto.

The input/output I/F 2030 may provide an interface for transmitting and receiving data by connecting an input device (not shown) such as a keyboard, a mouse, a touch panel, etc., and an output device such as a display (not shown), etc., to the MCU 2010.

The communication I/F 2040, which is a component capable of transmitting and receiving various data to and from a server, may be various devices capable of supporting wired or wireless communication. For example, the battery management apparatus 200 may transmit and receive various information including SOC, OCV, parameter, etc., of the battery cell from an external server separately provided through the communication I/F 2040.

As such, a computer program according to an embodiment disclosed herein may be recorded in the memory 2020 and processed by the MCU 2010, thus being implemented as a module that performs functions shown in FIG. 2.

Even though all components constituting an embodiment disclosed herein have been described above as being combined into one or operating in combination, the embodiments disclosed herein are not necessarily limited to the embodiments. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The foregoing disclosure may roughly show features of several embodiments to allow those of ordinary skill in the art to better understand aspects of the present disclosure. Those of ordinary skill in the art will appreciate that they may readily use the present disclosure as a basis for designing or modifying other structures to carry out the same purposes or achieve the same advantages of the embodiments introduced herein. Additionally, it would be recognized by those of ordinary skill in the art that such equivalent configurations may not depart from the scope of the present disclosure and various changes, substitutions, and modifications may be made herein without departing from the scope of the present disclosure.

## Claims

1. A battery management apparatus comprising:
a sensor configured to obtain a voltage of a battery unit; and
a controller configured to:
generate a differential profile for a first differential value that is variance of the voltage with respect to a variance of a state of charge (SOC) of the battery unit, based on the SOC and the voltage of the battery unit;
detect an SOC corresponding to each of second differential values included in a threshold range among second differential values obtained by differentiating the differential profile;
detect, from the differential profile, peak values of the differential profile among first differential values corresponding to the detected SOC; and
determine a state of the battery unit based on the peak values of the differential profile.

2. The battery management apparatus of claim 1, wherein the voltage comprises an open circuit voltage (OCV).

3. The battery management apparatus of claim 1, wherein the controller is further configured to compare an absolute value of the second differential values with a predetermined threshold value to detect an SOC corresponding to each of the second differential values included in the threshold range.

4. The battery management apparatus of claim 1, wherein the controller is further configured to determine the state of the battery unit based on a first peak value and a second peak value that are peak values included in a region of interest among the detected peak values of the differential profile.

5. The battery management apparatus of claim 4, wherein the controller is further configured to manage the state of the battery unit based on a deviation between SOCs respectively corresponding to the first peak value and the second peak value.

6. The battery management apparatus of claim 5, wherein the controller is further configured to determine that the battery unit is deteriorated more as the deviation between the SOCs respectively corresponding to the first peak value and the second peak value is smaller.

7. A battery management method comprising:
generating a differential profile for a first differential value that is variance of a voltage with respect to a variance of a state of charge (SOC) of the battery unit, based on the SOC and the voltage of the battery unit;
detecting an SOC corresponding to each of second differential values included in a threshold range among second differential values obtained by differentiating the differential profile;
detecting, from the differential profile, peak values of the differential profile among first differential values corresponding to the detected SOC; and
determining a state of the battery unit based on the peak values of the differential profile.

8. The battery management method of claim 7, wherein the voltage comprises an open circuit voltage (OCV).

9. The battery management method of claim 7, wherein the detecting of the SOC corresponding to each of the second differential values included in the threshold range comprises comparing an absolute value of the second differential values with a predetermined threshold value to detect an SOC corresponding to each of the second differential values included in the threshold range.

10. The battery management method of claim 7, wherein the determining of the state of the battery unit comprises determining the state of the battery unit based on a first peak value and a second peak value that are peak values included in a region of interest among the peak values of the differential profile.

11. The battery management method of claim 10, wherein the determining of the state of the battery unit comprises managing the state of the battery unit based on a deviation between SOCs respectively corresponding to the first peak value and the second peak value.

12. The battery management method of claim 11, wherein the determining of the state of the battery unit comprises determining that the battery unit is deteriorated more as the deviation between the SOCs respectively corresponding to the first peak value and the second peak value is smaller.
